# EUROPEAN PATENT APPLICATION

(11) **EP 2 299 479 A1**
(43) Date of publication of application: **23.03.2011**
(21) Application number: 09758260.5
(22) Date of filing: 28.05.2009
(51) Int. Cl.: H01L 21/3065, C23C 16/509, H01L 21/205

(54) **PLASMA PROCESSING APPARATUS, AND FILM FORMING METHOD AND ETCHING METHOD USING PLASMA PROCESSING APPARATUS**

(30) Priority: 02.06.2008 JP 2008144810
(71) Applicant: Sharp Kabushiki Kaisha, Osaka-shi, Osaka 545-8522 (JP)
(72) Inventor: KISHIMOTO, Katsushi, Osaka-shi, Osaka 545-8522 (JP); FUKUOKA, Yusuke, Osaka-shi, Osaka 545-8522 (JP); TANIGAWA, Nobuyuki, Osaka-shi, Osaka 545-8522 (JP)
(74) Representative: Müller - Hoffmann & Partner
(86) International application number: PCT/JP2009/059794
(87) International publication number: WO 2009/147993

(57) **Abstract**

A plasma processing apparatus, comprising:
a reaction chamber;
a plurality of discharge portions each made up of a pair of a first electrode and a second electrode disposed inside the reaction chamber so as to oppose to each other and to cause a plasma discharge under an atmosphere of a reactant gas; and
a dummy electrode, wherein
a plurality of the first electrodes are connected to a power supply portion,
a plurality of the second electrodes are grounded, and
the dummy electrode is disposed so as to oppose to an outer surface side of an external first electrode in terms of a parallel direction out of the plurality of the first electrodes which are disposed in the parallel direction, and is grounded.

## Description

### TECHNICAL FIELD

The present invention relates to a plasma processing apparatus, and a deposition method and an etching method using the plasma processing apparatus. More specifically, the present invention relates to a structure of a plasma processing apparatus having installed in its chamber a plurality of first electrode and second electrode pairs that cause plasma discharges.

### BACKGROUND ART

As a conventional plasma processing apparatus, a plasma processing apparatus of Prior Art 1 is known, in which a plurality of discharge portions, each causing a plasma discharge between electrodes, are disposed in a vertical order in a chamber (for example, see Patent Document 1).
In the plasma processing apparatus, among the electrodes, electrodes connected to a high frequency power supply and electrodes grounded are alternately disposed. Further, the plasma processing apparatus is structured such that, the electrodes except for a topmost electrode each include therein a heater, and the electrode except for a bottommost electrode each supplied with a reactant gas inside, such that the reactant gas is sprayed between each ones of the electrodes.

With the plasma processing apparatus of Prior Art 1 structured in this manner, a substrate is placed on each electrode except for the topmost electrode, and by a plasma discharge occurring in a space between each ones of the electrodes filled with the reactant gas, a deposition or an etching process takes place at a surface of the substrate.
However, because the plasma processing apparatus of Prior Art 1 is structured such that the substrates are placed without distinguishing between cathode electrodes and anode electrodes, and that the plasma discharge occurs between every ones of adjacent electrodes, the following problems arise.
(1) As to the deposition, both a film formed on each cathode electrode and a film formed on each anode electrode are resulted in a mixed up manner. On the other hand, as to the etching, both a substrate etched on each cathode electrode and a substrate etched on each anode electrode are resulted in a mixed up manner. Such events invite unfavorable results, such as formation of poor quality films due to the cathode electrodes unsuited for deposition undergoing such a process, and an execution of inappropriate etching processing due to the anode electrodes unsuited for the etching undergoing such a process.
(2) The problem (1) can be overcome by not placing the substrates on the electrodes unsuited for the deposition or the etching when carrying out the deposition or the etching. Nevertheless, the plasma discharges respectively occurring between adjacent electrodes cannot be controlled. As a result, such adjacent discharge portions interfere with each other, and hence the plasma discharges occurring at the discharge portions become extremely unstable.

As a solution for such problems, a plasma processing apparatus of Prior Art 2 shown in Fig. 7 has been proposed (for example, see Patent Document 2).
In the plasma processing apparatus, for example, discharge portions each made up of a cathode electrode 100 connected to a power supply portion E and an anode electrode 200 grounded are arranged in a plurality of numbers in a vertical order in a chamber. Each anode electrode 200 on a bottom side includes therein a heater 201, and a substrate S1 is placed on its top surface. On the other hand, into each cathode electrode 100, a reactant gas G represented by an arrow is introduced, and the reactant gas is sprayed from multitude of holes formed at a bottom surface of each cathode electrode 100. By a plasma discharge occurring between each of the cathode and anode electrode pairs under an atmosphere of the reactant gas, a film is formed on a surface of each substrate S 1.
While not shown in the drawing, the plasma processing apparatus is structured as an etching apparatus by placing each substrate on each cathode electrode disposed on the bottom side, and disposing each anode electrode on the top side. In this case, the reactant gas is introduced into each of the grounded anode electrodes, and the reactant gas is sprayed from multitude of holes formed at the bottom surface of each of the grounded anode electrodes toward each space formed between each of the cathode electrode and the anode electrode pairs. The heater is provided inside each of the cathode electrodes connected to the power supply.

Further, in either case where the plasma apparatus of Prior Art 2 is structured as the deposition apparatus or as the etching apparatus, the power supply portion E supplying a plurality of the cathode electrodes 100 with power is shared among them. In order to do this, an inter-discharge portion distance B between an anode electrode 200 of one discharge portion and a cathode electrode 100 of other discharge portion adjacent thereto is set to be at least twice as great as an interelectrode distance A between each cathode electrode 100 and each anode electrode 200. By setting the inter-discharge portion distance B to be at least twice as great as the interelectrode distance A, despite a presence of a plurality of the discharge portions in the chamber, an interference among them is prevented, whereby the deposition or the etching is carried out uniformly.

### PRIOR ART DOCUMENTS

### PATENT DOCUMENTS

Patent Document 1: US Patent No. 4,264,393
Patent Document 2: Japanese Patent Laid-open Publication No. 2006-120926

### SUMMARY OF THE INVENTION

### PROBLEMS TO BE SOLVED BY THE INVENTION

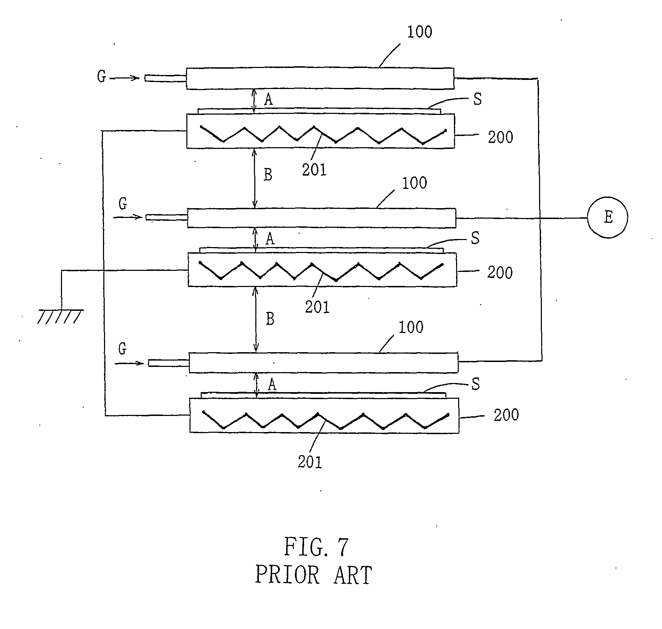

However, in the case of the deposition purpose plasma processing apparatus shown in Fig. 7, at every discharge portion except for the topmost discharge portion out of a plurality of the discharge portions, the anode electrode 200 is present above the cathode electrode 100, whereas no anode electrode 200 is present above the cathode electrode 100 in the topmost discharge portion.
On the other hand, in the case of the not-shown etching purpose plasma processing apparatus, at every discharge portion except for the bottommost discharge portion out of a plurality of the discharge portions, the anode electrode is present below the cathode electrode, whereas no anode electrode is present below the cathode electrode in the bottommost discharge portion.
In other words, the topmost or the bottommost cathode electrode is not sandwiched between the anode electrodes from above and below as the other cathode electrodes are. Therefore, an impedance of the topmost or the bottommost cathode electrode differs from that of the other cathode electrodes. This makes it impossible to equalize power supply amounts to the cathode electrodes, and hence the plasma discharges occurring at the discharge portions cannot be equalized. This leads to a disadvantageous unevenness between the deposition or the etching carried out at the topmost or the lowermost discharge portion and the deposition or the etching carried out at the other discharge portions.

The present invention has been made in consideration of such a problem, and an object thereof is to provide a plasma processing apparatus that can cause uniform plasma discharges at a plurality of discharge portions.

### MEANS FOR SOLVING THE PROBLEMS

Accordingly, the present invention provides a plasma processing apparatus, including:
a reaction chamber;
a plurality of discharge portions each made up of a pair of a first electrode and a second electrode disposed inside the reaction chamber so as to oppose to each other and to cause a plasma discharge under an atmosphere of a reactant gas; and
a dummy electrode, wherein
a plurality of the first electrodes are connected to a power supply portion,
a plurality of the second electrodes are grounded, and
the dummy electrode is disposed so as to oppose to an outer surface side of an external first electrode in terms of a parallel direction out of the plurality of the first electrodes which are disposed in the parallel direction, and is grounded.

Another aspect of the present invention provides a deposition method carried out by using
a plasma processing apparatus that includes a reaction chamber, a plurality of discharge portions each made up of a pair of a first electrode and a second electrode disposed inside the reaction chamber so as to oppose to each other and to cause a plasma discharge under an atmosphere of a reactant gas, and a dummy electrode disposed so as to oppose to an outer surface side of an external first electrode in terms of a parallel direction out of a plurality of the first electrodes which are disposed in the parallel direction, the method including the step of
depositing a semiconductor film on a substrate, wherein
in a state where the substrate is placed on each of at least one of the second electrodes, and where the plurality of the second electrodes and the dummy electrode are grounded and the plurality of the first electrodes are supplied with power, the plasma discharge is caused by use of the reactant gas, to thereby carry out the depositing of the semiconductor film on the substrate.

Further another aspect of the present invention provides an etching method carried out by using
a plasma processing apparatus that includes a reaction chamber, a plurality of discharge portions each made up of a pair of a first electrode and a second electrode inside the reaction chamber so as to oppose to each other and to cause a plasma discharge under an atmosphere of a reactant gas, and a dummy electrode disposed so as to oppose to an outer surface side of an external first electrode in terms of a parallel direction out of a plurality of the first electrodes which are disposed in the parallel direction, the method including the step of
etching one of a semiconductor substrate and a semiconductor film on a substrate, wherein
in a state where one of the semiconductor substrate and the substrate having the semiconductor film thereon is placed on each of at least one of the first electrodes, and where a plurality of the second electrodes and the dummy electrode are grounded and where the plurality of the first electrodes are supplied with power, the plasma discharge is caused by use of the reactant gas, to thereby carry out the etching of one of the semiconductor substrate and the semiconductor film on the substrate.

### EFFECT OF THE INVENTION

According to the present invention, by disposing the dummy electrode so as to oppose to the outer surface side of the external first electrode in terms of a parallel direction out of a plurality of the first electrodes, the external first electrode enters a state where it is disposed between the dummy electrode and one of the second electrodes, which state corresponds to a state where any other one of the first electrodes is disposed between two of the second electrodes.
That is, because a plurality of the first electrodes connected to the power supply portion are each disposed between the grounded electrodes (between the second electrodes or between the second electrode and the dummy electrode), it becomes possible to bring the plasma discharges occurring at a plurality of the discharge portions into a state where they uniformly match to one another.
In particular, in a case where, such as Prior Art 2 shown in Fig. 7, an external first electrode in terms of a parallel direction and other electrodes out of a plurality of the first electrodes are connected to an identical power supply portion, it has been difficult to match the impedance of the external first electrode to that of the other first electrodes, even if an adjustment of the power supply portion is carried out. In contrast thereto, according to the present invention, the impedance of the external first electrode can easily be matched to that of the other first electrodes.
As a result, a deposition step or an etching step in a manufacturing process of semiconductor devices can be carried out efficiently with a high accuracy.

### BRIEF DESCRIPTION OF THE DRAWINGS

Fig. 1 is a schematic configuration diagram showing a first embodiment of a plasma processing apparatus of the present invention.
Fig. 2 is a schematic configuration diagram showing a second embodiment of the plasma processing apparatus of the present invention.
Fig. 3 is a schematic configuration diagram showing a third embodiment of the plasma processing apparatus of the present invention.
Fig. 4 is a schematic configuration diagram showing a fourth embodiment of the plasma processing apparatus of the present invention.
Fig. 5 is a schematic configuration diagram showing a fifth embodiment of the plasma processing apparatus of the present invention.
Fig. 6 is a schematic configuration diagram showing a seventh embodiment of the plasma processing apparatus of the present invention.
Fig. 7 is a schematic configuration diagram showing a conventional deposition purpose plasma processing apparatus.

### MODE FOR CARRYING OUT THE INVENTION

A plasma processing apparatus of the present invention includes a reaction chamber, a plurality of discharge portions each made up of a pair of a first electrode and a second electrode disposed inside the reaction chamber so as to oppose to each other and to cause a plasma discharge under an atmosphere of a reactant gas, and a dummy electrode. A plurality of the first electrodes are connected to a power supply portion. A plurality of the second electrodes are grounded. The dummy electrode is disposed so as to oppose to an outer surface side of an external first electrode in terms of a parallel direction out of the plurality of first electrodes which are disposed in the parallel direction, and is grounded.
Here, the term "a plurality of discharge portions" refers to two or more discharge portions. The number of discharge portions (the assembly number) is not specifically limited and, for example, it may be two, three, four, five, or six.

This is described in more detail. The plasma processing apparatus further includes gas inlet portions that each introduce the reactant gas into the reaction chamber, an exhaust portion that exhausts the reactant gas from the reaction chamber, and support means for supporting and arranging in parallel the plurality of the first and the second electrodes and the dummy electrode in one of a horizontal manner and a vertical manner.
As used herein, to support and arrange in parallel the plurality of the first and the second electrodes and the dummy electrode in the horizontal manner means to align in a top-bottom direction the electrodes each being of a parallel plate type as lying on its side in the horizontal manner; and to support and arrange in parallel the plurality of the first and the second electrodes and the dummy electrode in the vertical manner means to align in a sideways direction the electrodes each being of the parallel plate type as standing upright in the vertical manner. That is, the plasma processing apparatus is a plasma processing apparatus that can be applied to both the top-bottom parallel type having a plurality of the parallel plate type discharge portions (electrode pairs) each made up of the first electrode and the second electrode aligned in the top-bottom direction, and the sideways parallel type having a plurality of parallel plate type discharge portions arranged in parallel in the sideways direction.
In the present invention, relative positions between each first electrode and each second electrode are not limited. That is, according to the present invention, each substrate being a processing target object that undergoes the plasma processing may be placed on either side of the first electrode or the second electrode. When the substrate is placed on each of the second electrodes, the present invention implements the deposition purpose plasma processing apparatus; and when the substrate is placed on each of the first electrodes, the present invention implements the etching purpose plasma processing apparatus.

In the plasma processing apparatus, as described above, the dummy electrode is disposed so as to oppose to the outer surface side of the external first electrode in terms of the parallel direction (i.e., one of the top-bottom direction and the sideways direction) out of the plurality of first electrodes. That is, the dummy electrode is a dummy second electrode for allowing the external first electrode to be disposed between two of the second electrodes (grounded electrodes) similarly to the other first electrodes.
By disposing the dummy electrode in this manner, it becomes possible to match the impedance of the external first electrode in terms of the parallel direction out of the plurality of first electrodes to the impedance of the other first electrodes. In other words, the impedance can be equalized among the first electrodes such that a quality of the substrates having undergone the plasma processing by the plasma discharges at the discharge portions is equalized.

This is described in more detail. For example, it is difficult to equalize the impedance among the first electrodes connected to an identical power supply portion, by adjusting the power supply portion.
According to the present invention, by disposing the dummy electrode on the outer surface side of the externally disposed first electrode, it becomes possible to equalize the impedance among the first electrodes connected to such an identical power supply portion.
It is to be noted that, the present invention also includes a plasma processing apparatus in which the external first electrode opposing to the dummy electrode and at least one other first electrode are connected to different power supply portions. In this case, variations in the impedance among the first electrodes are smaller than those in the plasma processing apparatus having no dummy electrode. Therefore, the impedance can more easily be matched among the first electrodes.

As has been described above, in order to match the impedance among the first electrodes, and to carry out the deposition or the etching at the discharge portions accurately and uniformly, it is preferable that the dummy electrode is disposed such that a distance between the dummy electrode and a first electrode opposing to the dummy electrode is matched to an inter-discharge portion distance between a second electrode of one (arbitrary) discharge portion and a first electrode of other discharge portion adjacent thereto. In other words, it is preferable to conform (to substantially match) the distance between the dummy electrode and the first electrode opposing to the dummy electrode to the inter-discharge portion distance, such that the substrates having undergone the plasma processing by the plasma discharges occurring at the discharge portions achieve a more equalized quality.

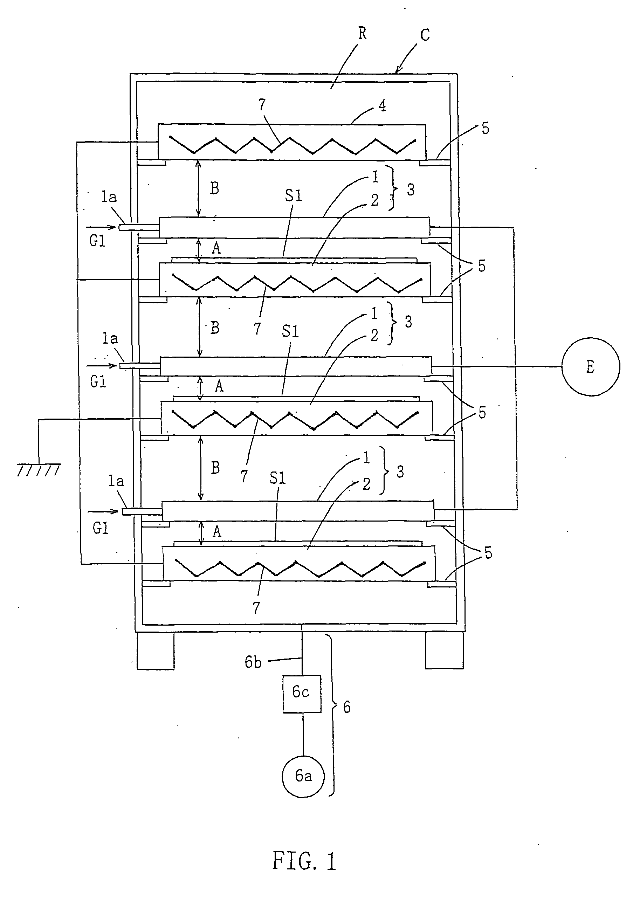

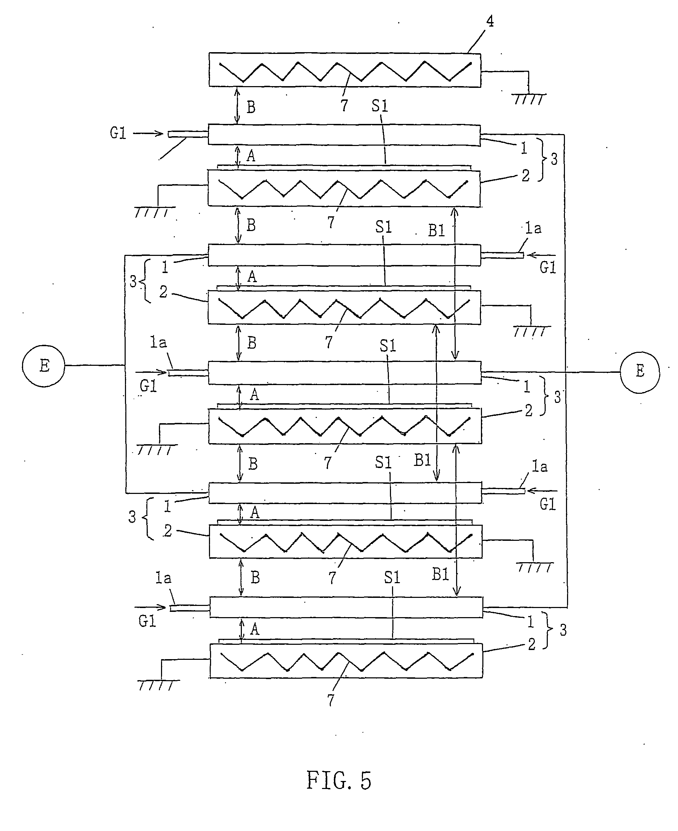

The plasma processing apparatus according to the present invention is applicable to, for example, a plasma processing apparatus (I) in which a first electrode opposing to a dummy electrode and a first electrode of a discharge portion adjacent to the first electrode are connected to an identical power supply portion (for example, see Fig. 1), and a plasma processing apparatus (II) in which a first electrode opposing to a dummy electrode and a first electrodes of any discharge portion non-adjacent to the first electrode are connected to an identical power supply portion (for example, see Fig. 5). However, the present invention is not limited thereto.
The case (I) includes a case in which respective first electrodes of two or more discharge portions on the dummy electrode side being adjacent to one another are connected to the identical power supply portion. The case (II) includes a case in which three or more discharge portions counted from the dummy electrode side are disposed, and between any ones of a plurality of first electrodes including the first electrode that oppose to the dummy electrode all of which are connected to the identical power supply portion, a discharge portion having a first electrode connected to a different power supply portion is disposed.

In the plasma processing apparatus, as the power supply portion, a power supply portion including a high frequency generator and an amplifier that amplifies high frequency power from the high frequency generator and supplies the amplified high frequency power to the first electrodes may be employed. A connection mode between respective first electrodes of the discharge portions and the power supply portion is not specifically limited.
In other words, a first electrode of one discharge portion out of all the discharge portions and a first electrode of other discharge portion adjacent thereto are connected in one of the following manners: (a) they are connected to an identical high frequency generator via an identical amplifier; (b) they are connected to an identical high frequency generator respectively via separate amplifiers; and (c) they are respectively connected to different high frequency generators via an amplifier. It is to be noted that, in the connection modes (a) to (c), at least two discharge portions are connected to an identical power supply portion.

Further, in accordance with the connection modes (a) to (c), an inter-discharge portion distance B between a second electrode of one discharge portion and a first electrode of other discharge portion adjacent thereto relative to an interelectrode distance A between the first electrode and the second electrode in each discharge portion is defined as follows.
In the case of the connection mode (a), the inter-discharge portion distance B is set to at least twice as great as the interelectrode distance A (B/A ≥ 2), and a distance between the dummy electrode and the opposing first electrode is matched to the inter-discharge portion distance B, preferably, being set to be equal to the inter-discharge portion distance B. In the case of the connection mode (a), respective first electrodes of adjacent discharge portions are connected to the power supply portion via the same electrical system. Therefore, in order to prevent interference between respective plasma discharges occurring at the adjacent discharge portions, the inter-discharge portion distance B must be at least twice as great as the interelectrode distance A.
The connection mode (a) corresponds to the plasma processing apparatus (I) described above.

On the other hand, in the case of one of the connection modes (b) and (c), the inter-discharge portion distance B is set to at least 1.5 times as great as the interelectrode distance A (B/A ≥ 1.5), and the distance between the dummy electrode and the opposing first electrode is matched to the inter-discharge portion distance B, preferably, being set to be equal to the inter-discharge portion distance B. In the case of one of the connection modes (b) and (c), the first electrodes of adjacent discharge portions are connected to the power supply portion respectively via different electrical systems. Therefore, the plasma discharges occurring at the adjacent discharge portions are less prone to interfere with each other than in the connection mode (a), whereby it becomes possible to narrow the inter-discharge portion distance B than that in the connection mode (a).
The connection modes (b) and (c) correspond to the plasma processing apparatus (II) described above.

Meanwhile, the first electrodes, the second electrodes and dummy electrode formed to be plate-like and disposed so as to be parallel to one another suffer from deflections caused by their own weights, in particular when they are supported in the horizontal manner by the support means. The deflections have an effect on the interelectrode distance A and the distance B.
Accordingly, for the purpose of matching the plasma discharges occurring at a plurality of the discharge portions to one another uniformly with a higher accuracy by matching the impedance among a plurality of the first electrodes with a higher accuracy, it is desirable to take into consideration of the deflection in each of the first electrodes, the second electrodes and the dummy electrode.
To this end, in the present invention, the following structures are possible. It is to be noted that the following structures are applicable to a case where a first electrode of a discharge portion opposing to (adjacent to) the dummy electrode and a first electrode of at least one other discharge portion are connected to an identical power supply portion, and to a case where the first electrode of the discharge portion opposing to the dummy electrode and the first electrode of all the other discharge portion(s) are connected to a different power supply portion.

(1-1) The second electrodes and the dummy electrode are identical to each other in at least one of a shape, a size and a material. It is preferable that each second electrode and the dummy electrode are identical to each other at least two of the shape, the size and the material, and it is more preferable that they are identical to each other in all the three items.
(1-2) In a case where a first electrode of one discharge portion adjacent to the dummy electrode and a first electrode of at least one other discharge portion are connected to an identical power supply portion, a second electrode of a discharge portion adjacent to the other discharge portion and the dummy electrode are identical to each other in the shape, the size and the material.
These structures are applicable to first to eighth embodiments whose description will follow.

(2) The first electrodes, the second electrodes and the dummy electrode are structured with respective shapes, sizes and materials whereby their respective deflection amounts match to one another. As used herein, "their respective deflection amounts match to one another" mean that the deflection amounts are nearly identical to one another, such that respective plasma discharges at the discharge portions match one another in a range not affecting a quality of processing target objects.
These structures also are applicable to the first to eighth embodiments.

(3-1) The second electrodes and the dummy electrode are grounded at an identical point in each electrode.
(3-2) In a case where a first electrode of one discharge portion adjacent to the dummy electrode and a first electrode of at least one other discharge portion are connected to an identical power supply portion, a second electrode of a discharge portion adjacent to the other discharge portion and the dummy electrode are grounded at an identical point in each electrode.
These structures also are applicable to the first to eighth embodiments.

(4-1) The second electrodes and a second electrode of the other discharge portion are grounded at an identical point in each electrode.
(4-2) In a case where a first electrode of one discharge portion adjacent to the dummy electrode and a first electrode of at least one other discharge portion are connected to an identical power supply portion, a second electrode of the one discharge portion and a second electrode of the other discharge portion are grounded at an identical point in each electrode.
These structures also are applicable to the first to eighth embodiments.

(5-1) The first electrodes are connected to the power supply portion at an identical point in each electrode.
(5-2) A plurality of the first electrodes connected to an identical power supply portion are connected to the power supply portion at an identical point in each electrode.
These structures also are applicable to the first to eighth embodiments.

(6-1) The second electrodes and the dummy electrode respectively include therein heaters, the heaters preferably being capable of generating heat at an identical temperature.
(6-2) In a case where a first electrode of one discharge portion adjacent to the dummy electrode and a first electrode of at least one other discharge portion are connected to an identical power supply portion, a second electrode of a discharge portion adjacent to the other discharge portion and the dummy electrode respectively include therein heaters, the heaters preferably being capable of generating heat at an identical temperature.
These structures also are applicable to the first to eighth embodiments.
It is to be noted that the structures described in the foregoing can selectively be combined.

The structures (1-2), (3-2), (4-2), (5-2), and (6-2) described in the foregoing establish preferable states, especially in the case where the first electrode of the discharge portion opposing (adjacent) to the dummy electrode and the first electrode of at least one other discharge portion are connected to the identical power supply portion, in terms of matching the impedance among a plurality of the first electrodes connected to the identical power supply portion with a higher accuracy.

According to the structures of (1-1) and (1-2) described in the foregoing, it becomes easier to match amounts of deflection (deflection amounts) to one another among the second electrodes and the dummy electrode, which are caused by their own weights. By causing the second electrodes and the dummy electrode to be identical to each other in at least two of the shape, the size and the material, the deflection amounts caused by their own weights can approximate one another. Preferably, by causing the second electrodes and the dummy electrode to be identical to each other in all the size and the material, their deflection amounts can be equalized.
Accordingly, even if the second electrodes and the dummy electrode deflect by their own weights, each inter-discharge portion distance B and the distance between the dummy electrode and the opposing first electrode (= inter-discharge portion distance B) can be equalized, or they can approximate one another. As a result, as noted above, the impedance can be matched among a plurality of the first electrodes with the higher accuracy.

According to the structure of (2) described in the foregoing, in addition to each inter-discharge portion distance B and the distance between the dummy electrode and the opposing first electrode being equalized, the optimum interelectrode distance A for the plasma discharge at each discharge portion can be maintained. As a result, as noted above, the impedance can be matched among a plurality of the first electrodes with the higher accuracy.
According to the structures of (3-1), (3-2), (4-1), (4-2), (5-1), and (5-2) described in the foregoing, it becomes easier for respective plasma discharges occurring at the discharge portions to stabilize.

The heaters in the structures of (6-1) and (6-2) are respectively included in the second electrodes for heating substrates being the processing target objects when undergoing the plasma processing. In the cases of (6-1) and (6-2), the dummy electrode similarly includes such a heater, to heat the dummy electrode as the second electrodes do when carrying out the plasma processing, and preferably, to heat the dummy electrode at the same temperature as the second electrode. This makes it possible to equalize the effect of the heat of the second electrodes and that of the heat of the dummy electrode. Further, by heating the second electrodes and the dummy electrode to the same temperature, the effect of deflections caused by the heat of the first electrodes can be equalized, and the effect of deflection caused by heat of each first electrode interposed between the second electrodes and that of the first electrode interposed between the second electrode and the dummy electrode can be equalized. Thus, the effects of the deflections caused by heat can be equalized. As a result, as noted above, the impedance can be matched among a plurality of the first electrodes with the higher accuracy.

In the following, with reference to the drawings, specific embodiments of the plasma processing apparatus of the present invention will be described.

### (First Embodiment)

Fig. 1 is a schematic configuration diagram showing a first embodiment of the plasma processing apparatus of the present invention.
The plasma processing apparatus of the first embodiment is a top-bottom parallel type deposition purpose plasma processing apparatus that deposits a desired film on a surface of a substrate S1 being a processing target object, the apparatus including a reaction chamber R, gas inlet portions 1a that introduce a reactant gas G1 into the reaction chamber R, an exhaust portion 6 that exhausts the reactant gas G1 from the reaction chamber R, a plurality of discharge portions 3 each made up of a pair of a first electrode 1 and a second electrode 2 disposed to oppose to each other inside the reaction chamber R to cause a plasma discharge under an atmosphere of the reactant gas G1, a dummy electrode 4, and support means 5 for arranging in parallel and supporting a plurality of the first and the second electrodes 1 and 2 and the dummy electrode 4 in a horizontal manner.

In the plasma processing apparatus, a plurality of the first electrodes 1 are connected to a single power supply portion E; a plurality of the second electrodes 2 are grounded; and the dummy electrode 4 is disposed so as to oppose to an outer surface side of an external first electrode 1 in terms of a parallel direction out of the plurality of the first electrodes 1, the dummy electrode 4 being grounded.
In Fig. 1, the power supply portion E includes a high frequency generator and an amplifier that amplifies high frequency power from the high frequency generator and supplies the amplified high frequency power to the first electrodes. Respective first electrodes of adjacent discharge portions are connected to the identical high frequency generator via the identical amplifier as in the connection mode (a). It is to be noted that, while Fig. 1 shows the plasma processing apparatus in which the discharge portions 3 are disposed three in number in a vertical order, the number of the discharge portions 3 may be two, or four or more.
In the following, in the embodiments of the present invention, each first electrode 1 is referred to as a cathode electrode 1, and each second electrode 2 is referred to as an anode electrode 2.

The reaction chamber R is structured with a sealable chamber C that accommodates a plurality of the discharge portions 3 and the dummy electrode 4.
The chamber C is box-shaped to which the exhaust portion 6 is connected. At a chamber inner wall surface, the support means 5 for supporting a plurality of the cathode electrodes 1 and a plurality of the anode electrodes 2 is formed.
The exhaust portion 6 includes a vacuum pump 6a, an exhaust pipe 6b that connects the vacuum pump 6a and the reaction chamber R, and a vacuum controller 6c disposed between the reaction chamber R and the vacuum pump 6a in the exhaust pipe 6b.

The support means 5 is implemented by support pieces that each project by a prescribed dimension from the inner wall surface of the chamber C in a horizontal direction. The support pieces are provided at a plurality of vertical places of the inner wall surface of the chamber C at prescribed intervals, so as to support the cathode electrodes 1 and the anode electrodes 2 each being flat plate-shaped to be parallel to one another and in the horizontal manner, and to support the dummy electrode 4 in the horizontal manner. In the first embodiment, the support means 5 is provided seven in number, so as to support four corners of bottom surfaces of three pairs of the cathode and anode electrodes 1 and 2 and the dummy electrode 4.

Here, the support means 5 at each place is disposed at a height position whereby an inter-discharge portion distance B between an anode electrode 2 of one discharge portion 3 and a cathode electrode 1 of other discharge portion 3 adjacent thereto becomes at least twice as great as an interelectrode distance A between each cathode electrode 1 and each anode electrode 2 in each discharge portion 3, and a distance between the dummy electrode 4 and a topmost cathode electrode 1 becomes equal to the inter-discharge portion distance B. For example, the interelectrode distance A is set to 2 to 30 mm, and the inter-discharge portion distance B is set to 4 to 60 mm or more. An in-plane accuracy of the interelectrode distance A is preferably within several presents, and particularly preferably equal to or smaller than 1 percent.

Each of the anode electrodes 2 includes therein a heater 7, and has the substrate S1 disposed on its top surface, to heat the substrate S1 when forming a film under plasma discharge conditions. It is to be noted that, while each substrate S1 is generally a silicon substrate, a glass substrate and the like, the present invention is not particularly limited thereto.
Further, the anode electrodes 2 are made of an electrically conductive and heat resistant material such as stainless steel, aluminum alloy, carbon or the like.
Dimensions of each of the anode electrodes 2 are set to appropriate values, so as to conform to dimensions of the substrate S 1 for forming a thin film. For example, the dimensions of each of the anode electrodes 2 are designed to be 1000 to 1500 mm × 600 to 1000 mm, for the substrate S1 measuring 900 to 1500 mm × 400 to 1200 mm.
The heater 7 included in each of the anode electrodes 2 is to perform controlled heating of the anode electrodes 2 in a range of a room temperature to 300°C. For example, an element made up of an aluminum alloy including therein an encapsulated heating apparatus such as a sheath heater and an encapsulated temperature sensor such as a thermocouple can be employed as the heater 7.

The cathode electrodes 1 are prepared from the stainless steel, the aluminum alloy or the like. Dimensions of each of the cathode electrodes 1 are set to appropriate values, so as to conform to the dimensions of the substrate S1 on which the deposition is carried out. The cathode electrodes 1 can each be designed to have the same dimensions (a plane size and a thickness) as those of the anode electrodes 2. Further, each cathode electrode 1 is set to have a same deflection amount (rigidity) as that of each anode electrode 2. In this case, each cathode electrode 1 may be or may not be identical to each anode electrode 2 in the shape, the size, and material, so long as they are identical to each other in the deflection amount.
An interior of each of the cathode electrodes 1 is cavity. A plasma discharge surface of each of the cathode electrodes 1 that opposes to its paired one of the anode electrodes 2 is provided with a multitude of through holes by a perforation working. This perforation working is desirably carried out so as to form circular holes each having a diameter of 0.1 mm to 2 mm with a spacing of a several mm to several cm.
To one end surface of each of the cathode electrodes 1, a gas inlet pipe as the gas inlet portion 1a is connected. A not-shown gas supply source and each gas inlet portion 1a are connected to each other by a connection pipe, such that the reactant gas G1 is supplied from the gas supply source into inside each cathode electrode 2, and is sprayed from the multitude of through holes toward the surface of the substrate S1. It is noted that, as the raw gas, for example, an SiH₄ (monosilane) gas diluted with H₂ is used.

The cathode electrodes 1 are supplied with power from a plasma excitation power supply as the power supply portion E. As this power, power of, for example, 10 W to 100 kW at an AC frequency of 1.00 MHz to 60 MHz, specifically, power of 10 W to 10 kW at 13.56 MHz to 60 MHz is used. An impedance matching unit, an amplifier or the like (each not shown) may be disposed at the electrical path between the power supply portion E and the cathode electrodes 1.

It is preferable that the dummy electrode 4 is identical to the anode electrodes 2 in the deflection amount (rigidity), and is prepared to be identical in the material, the shape and the size. Further, the dummy electrode 4 includes therein a heater 7 that is identical to the heater 7 of each anode electrode 2. That is, the dummy electrode 4 is structured similarly to each anode electrode 2.

Thus, the deposition purpose plasma processing apparatus of the first embodiment is structured as the structures (1-2), (2), (3-2), (4-2), (5-2), and (6-2) described in the foregoing.

A deposition method using the deposition purpose plasma processing apparatus structured in the manners described above includes a step of depositing a semiconductor film on each substrate, in which: in a state where the substrate is placed on at least one second electrode; a plurality of the second electrodes and the dummy electrode are grounded; and a plurality of the first electrodes are supplied with power, plasma discharges are caused to occur by use of the reactant gas, to thereby carry out the deposition on the substrate.
This is described in more detail. By filling a gap between each cathode electrode 1 and each anode electrode 2 with the reactant gas G1 being a film material at a prescribed flow rate and a prescribed pressure, and applying the high frequency power to each cathode electrode 1 and each anode electrode 2, it becomes possible to produce a glow discharge region (a plasma discharge region) between each cathode electrode 1 and each anode electrode 2, so as to form an amorphous film or a crystalline film on each substrate S1. For example, by using SiH₄ gas diluted with H₂ as the raw gas, a silicon thin film having a thickness of 300 nm can be deposited within a thickness distribution of ± 10%.

Here, the cathode electrodes 1 in a plurality of the discharge portions 3 are each in the same state as being disposed between the anode electrode 2 and the dummy electrode 4. This makes it possible to match the impedance of the external cathode electrode 1 to the impedance of other cathode electrodes 1. Further, because the anode electrodes 2 and the dummy electrode 4 are structured to be identical to each other in the material, the shape and the size, and the dummy electrode 4 also heats the topmost cathode electrode 1 from above at the same temperature as the anode electrodes 2 do, the deflection amounts among the electrodes 2 and 4 become equivalent. Accordingly, every interelectrode distance A becomes equivalent, and every inter-discharge portion distance B becomes equivalent. Further, because the cathode electrodes 1 are set to have the same deflection amount as that of the anode electrodes 2, the interelectrode distance A between each cathode electrode 1 and each anode electrode 2 is maintained at a high accuracy.
Thanks to these facts, with the plasma processing apparatus of the first embodiment, a deposition step in a manufacturing process of semiconductor devices can be carried out efficiently with a high accuracy.

### (Second Embodiment)

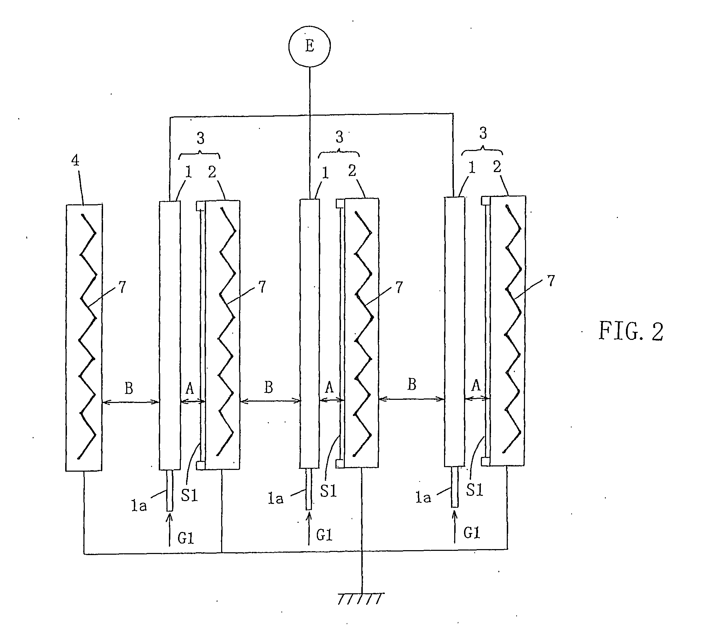

Fig. 2 is a schematic configuration diagram showing a second embodiment of the plasma processing apparatus of the present invention. In Fig. 2, constituents that are identical to those shown in Fig. 1 are denoted by identical reference characters.
The plasma processing apparatus of the second embodiment is also the deposition purpose plasma processing apparatus, and a major difference from the first embodiment (of the top-bottom parallel type) lies in that the plasma processing apparatus of the second embodiment is of a sideways parallel type. That is, the plasma processing apparatus of the second embodiment corresponds to that of the plasma processing apparatus of the first embodiment substantially lying on its side, the structure of the plasma processing apparatus of the first embodiment having been described with reference to Fig. 1. Similarly to the first embodiment, the second embodiment is also structured as the structures (1-2), (2), (3-2), (4-2), (5-2), and (6-2) described in the foregoing.
While the chamber C, the support means 5 and the exhaust portion 6 shown in Fig. 1 are omitted from Fig. 2, the plasma processing apparatus of the second embodiment also includes these constituents. However, according to the second embodiment, in order to support the cathode electrodes 1, the anode electrodes 2 and the dummy electrode 4 in a vertical manner, the support means is configured by support pieces that project in the top-bottom direction from a top inner wall surface and a bottom inner wall surface of the chamber, to thereby clamp the electrodes from opposite sides. Further, on a substrate placement plane of each anode electrode 2, protrusion portions that hold each substrate S1 are formed.

As in the first embodiment, in the plasma processing apparatus of the second embodiment also, by filling the gap between each cathode electrode 1 and each anode electrode 2 with the reactant gas G1 being the film material at a prescribed flow rate and a prescribed pressure, and applying the high frequency power to each cathode electrode 1 and each anode electrode 2, it becomes possible to produce a glow discharge region (a plasma discharge region) between each cathode electrode 1 and each anode electrode 2, so as to form the amorphous film or the crystalline film on each substrate S1.

Here, because respective cathode electrodes 1 in a plurality of the discharge portions 3 are in the same state in which each as being disposed between anode electrode 2 and the dummy electrode 4, the impedance is matched among them.
Further, because the plasma processing apparatus of the second embodiment is of the sideways parallel type in which the electrodes 1, 2, and 4 are vertically supported, the effect of the deflection at each electrode as seen in the first embodiment is small. In addition thereto, the dummy electrode 4 also heats sideways the external (left in Fig. 2) cathode electrode 1 at the same temperature as the anode electrodes 2 do. Thus, there exist little variations in each interelectrode distance A and each inter-discharge portion distance B.
Thanks to these facts, with the plasma processing apparatus of the second embodiment also, the deposition step in the manufacturing process of the semiconductor devices can be carried out efficiently with the high accuracy.

### (Third Embodiment)

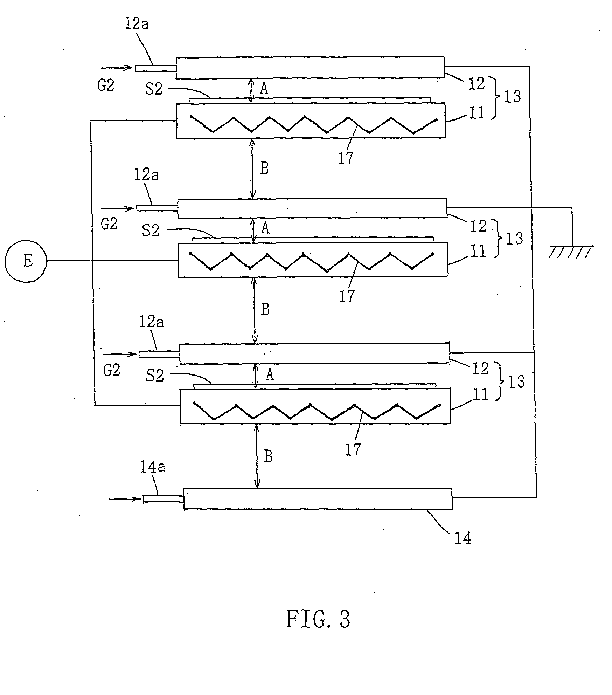

Fig. 3 is a schematic configuration diagram showing a third embodiment of the plasma processing apparatus of the present invention. In Fig. 3, constituents that are identical to those shown in Fig. 1 are denoted by the identical reference characters.
The plasma processing apparatus of the third embodiment is an etching purpose plasma processing apparatus of the top-bottom parallel type. As in the first embodiment, the plasma processing apparatus includes a plurality of discharge portions 13 each made up of a pair of a cathode electrode 11 and an anode electrode 12, a dummy electrode 14, a not-shown chamber, not-shown support means and a not-shown exhaust portion.

A major difference of the third embodiment from the first embodiment lies in that, in each discharge portion 13, the cathode electrode 11 and the anode electrode 12 are inversely disposed in terms of their relative top-bottom positions, each substrate S2 being placed on each cathode electrode 11 connected to the power supply portion E, and each grounded anode electrode 12 being disposed above each substrate S2. It is to be noted that, in the case of the third embodiment, the grounded dummy electrode 14 is disposed below the bottommost cathode electrode 11.

In this case, similarly to the cathode electrode 1 of the first embodiment, each anode electrode 12 of the third embodiment includes gas inlet portions 12a for introducing a reactant gas G2 inside, and provided with multitude of through holes at its bottom surface for the reactant gas G2 to be sprayed.
Further, similarly to each anode electrode 2 of the first embodiment, each cathode electrode 11 of the third embodiment includes therein a heater 17.
Still further, the dummy electrode 14 may be structured similarly to each anode electrode 12. However, the dummy electrode 14 may be or may not be connected to the gas supply source. Even when dummy electrode 14 is connected to the gas supply source, it is not necessary for the dummy electrode 14 to be supplied with the reactant gas.

Similarly to the first embodiment, the third embodiment is also structured as the structures (1-2), (2), (3-2), (4-2), (5-2), and (6-2) described in the foregoing. Further, similarly to the first embodiment, in the third embodiment, an inter-discharge portion distance B between a cathode electrode 11 of one discharge portion 13 and an anode electrode 12 of other discharge portion 13 adjacent thereto is set to at least twice as great as an interelectrode distance A between each cathode electrode 11 and each anode electrode 12 in each discharge portion 13, and a distance between the dummy electrode 14 and a bottommost cathode electrode 11 is equal to the inter-discharge portion distance B. For example, the interelectrode distance A is set to 2 to 30 mm, and the inter-discharge portion distance B is set to 4 to 60 mm or more. An in-plane accuracy of the interelectrode distance A is preferably within several percents, and particularly preferably equal to or smaller than 1 percent.

An etching method using the etching purpose plasma processing apparatus structured in this manner includes a step of etching a semiconductor substrate or a semiconductor film on a substrate, in which: in a state where the semiconductor substrate or the substrate having a semiconductor film thereon is placed on each of at least one first electrode; a plurality of the second electrodes and the dummy electrode are grounded; and a plurality of the first electrodes are supplied with power, plasma discharges are caused to occur by use of the reactant gas, to thereby etch each semiconductor substrate or the semiconductor film on the substrate.
This is described in more detail. For example, by filling the gap between each cathode electrode 11 and each anode electrode 12 with the reactant gas G2 being an etching gas obtained by diluting a fluorinated gas with an inert gas such as argon at a prescribed flow rate and a prescribed pressure, and applying high frequency power to each cathode electrode 11 and each anode electrode 12, it becomes possible to produce a glow discharge region (a plasma discharge region) between the cathode electrode 11 and the anode electrode 12, and to efficiently etch each substrate S2 (for example, a silicon substrate) at a rate equal to or greater than 10 nm/s.

Here, because respective cathode electrodes 11 in a plurality of the discharge portions 13 are in the same state, i.e., each as being disposed between anode electrode 12 and the dummy electrode 14, the impedance is matched among them.
Further, because the anode electrodes 12 and the dummy electrode 14 are structured to be identical to each other in the material, the shape and the size, and the dummy electrode 14 also is heated by the bottommost cathode electrode 11, the deflection amounts among the electrodes 12 and 14 become equivalent, while each interelectrode distance A becomes equivalent and each inter-discharge portion distance B becomes equivalent. Further, because the cathode electrodes 11 are set to have the same deflection amount as that of the anode electrodes 2, the interelectrode distance A between each cathode electrode 1 and each anode electrode 2 is maintained at the high accuracy.
Thanks to these facts, with the plasma processing apparatus of the third embodiment, an etching step in the manufacturing process of the semiconductor devices can be carried out efficiently with the high accuracy.

### (Fourth Embodiment)

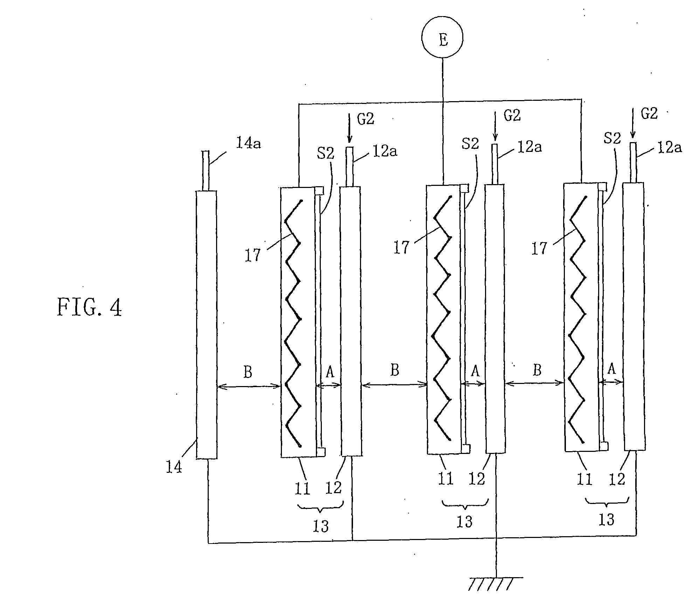

Fig. 4 is a schematic configuration diagram showing a fourth embodiment of the plasma processing apparatus of the present invention. In Fig. 4, constituents that are identical to those shown in Fig. 3 are denoted by the identical reference characters.
The plasma processing apparatus of the fourth embodiment is also the etching purpose plasma processing apparatus, and a major difference from the third embodiment (of the top-bottom parallel type) lies in that the plasma processing apparatus of the fourth embodiment is of a sideways parallel type. That is, a structure of the plasma processing apparatus of the fourth embodiment corresponds to that of the plasma processing apparatus of the third embodiment lying on its side, the structure of the plasma processing apparatus of the third embodiment having been described with reference to Fig. 3.
As in the third embodiment, the plasma processing apparatus of the fourth embodiment also includes a plurality of discharge portions 13 each made up of a pair of a cathode electrode 11 and an anode electrode 12, a dummy electrode 14, a not-shown chamber, not-shown support means and a not-shown exhaust portion. However, according to the fourth embodiment, in order to support the cathode electrodes 11, the anode electrodes 12 and the dummy electrode 14 in the vertical manner, the support means is configured by support pieces that project in the top-bottom direction from a top inner wall surface and a bottom inner wall surface of the chamber, to thereby clamp the electrodes from opposite sides. Further, on a substrate placement plane of each anode electrode 12, protrusion portions that hold each substrate S2 are formed.

Similarly to the first embodiment, the fourth embodiment is also structured as the structures (1-2), (2), (3-2), (4-2), (5-2) and (6-2) described in the foregoing. Further, similarly to the third embodiment, with the plasma processing apparatus of the fourth embodiment also, for example, by filling the gap between each cathode electrode 11 and each anode electrode 12 with a reactant gas G2 being an etching gas obtained by diluting a fluorinated gas with an inert gas such as argon at a prescribed flow rate and a prescribed pressure, and applying high frequency power to each cathode electrode 11 and each anode electrode 12, it becomes possible to produce a glow discharge region (a plasma discharge region) between the cathode electrode 11 and the anode electrode 12, and to efficiently etch each substrate S2 (for example, a silicon substrate) at a rate equal to or greater than 10 nm/ s.

Here, because respective cathode electrodes 11 in a plurality of the discharge portions 13 are in the same state, i.e., each as being disposed between the anode electrode 12 and the dummy electrode 14, the impedance is matched among them.
Further, because the plasma processing apparatus of the fourth embodiment is of the sideways parallel type in which the electrodes 11, 12, and 14 are vertically supported, the effect of the deflection at each electrode as seen in the third embodiment is small. In addition thereto, because the dummy electrode 14 is also heated by the external cathode electrode 11 (left in Fig. 3), each interelectrode distance A becomes equivalent and each inter-discharge portion distance B becomes equivalent.
Thanks to these facts, with the plasma processing apparatus of the third embodiment, the etching step in the manufacturing process of the semiconductor devices can be carried out efficiently with the high accuracy.

### (Fifth Embodiment)

Fig. 5 is a schematic configuration diagram showing a fifth embodiment of the plasma processing apparatus of the present invention. In Fig. 5, constituents that are identical to those shown in Fig. 1 are denoted by the identical reference characters.
The plasma processing apparatus of the fifth embodiment is the top-bottom parallel type deposition purpose plasma processing apparatus as in the first embodiment shown in Fig. 1, and is similarly structured as that of the first embodiment, except for a major difference in the connection mode between a plurality of the cathode electrodes 1 and the power supply portion E.

That is, in the case of the plasma processing apparatus, respective cathode electrodes 1 of at least two of the discharge portions 3 are connected to an identical power supply portion E, and respective cathode electrodes 1 of adjacent ones of the discharge portions 3 are: connected to an identical high frequency generator via separate amplifiers as in the connection mode (b); or connected to different high frequency generators via an amplifier as in the connection mode (c). In other words, respective cathode electrodes 1 of the adjacent ones of the discharge portions 3 are connected to the power supply portion E via different electrical systems. While the power supply portion E is illustrated two in number in Fig. 5, it does not necessarily mean use of the separate high frequency generators.
By connecting the cathode electrodes 1 to the power supply portion E in this manner, it becomes possible to set the inter-discharge portion distance B to be at least 1.5 times as great as the interelectrode distance A, which is narrower than that in the first embodiment.

In a plurality of discharge portions 3 connected with the identical electrical system, it is preferable that the relative positional relationship between every cathode electrode 1 and the power supply position is identical, and that the relative positional relationship between every anode electrode 2 and the ground position is identical. As used herein, the state where "the relative positional relationship is identical" refers to a state in which the power supply position is identical in every cathode electrode 1 when each cathode electrode 1 is seen in plan view, and the ground position is identical in every anode electrode 2 when each anode electrode 2 is seen in plan view.
Thus, it becomes possible to more equally supply power from the power supply portion E to respective cathode electrodes 1 of a plurality of the discharge portions 3 connected with the identical electrical system.

That is, similarly to the first embodiment, the fifth embodiment is also structured as the structures (1-2), (2), (3-2), (4-2), (5-2), and (6-2) described in the foregoing.
In particular, a detailed description will be given of (1), (3-2), (4-2), (5-2), and (6-2). For example, in Fig. 5, the midmost (the third from the top) discharge portion 3 is in an environment being sandwiched from above and below by the second and fourth discharge portions 3 that are connected to a different power supply portion E. Because it is preferable that the first discharge portion 3 is in the same environment as the third discharge portion 3, the dummy electrode 4 that opposes to the first electrode 1 of the first discharge portion 3 is formed to be identical to the second electrode 2 of the second discharge portion 3 that opposes to the first electrode 1 of the third discharges portion 3 in the shape, the size, and the material, and to be identical in the grounded point, and to similarly include a heater. In this case, the dummy electrode 4 is not limited to be alike the second electrode 2 of the second discharge portion 3, and may be alike the second electrode 2 of the fourth discharge portion 3. Further, in the case of the fifth embodiment, the discharge portions connected to the different power supply portions E may be identical or different in the structure of the first electrode 1, and may be identical or different in the structure of the second electrode.

### (Sixth Embodiment)

With reference to Fig. 5, the description has been given of the top-bottom parallel type deposition purpose plasma processing apparatus. It is also possible to employ a sideways parallel type deposition purpose plasma processing apparatus, whose structure corresponds to that of the aforementioned top-bottom parallel type deposition purpose plasma processing apparatus substantially lying on its side (not shown). Similarly to the first embodiment, the sixth embodiment is also structured as the structures (1-2), (2), (3-2), (4-2), (5-2), and (6-2) described in the foregoing.

### (Seventh Embodiment)

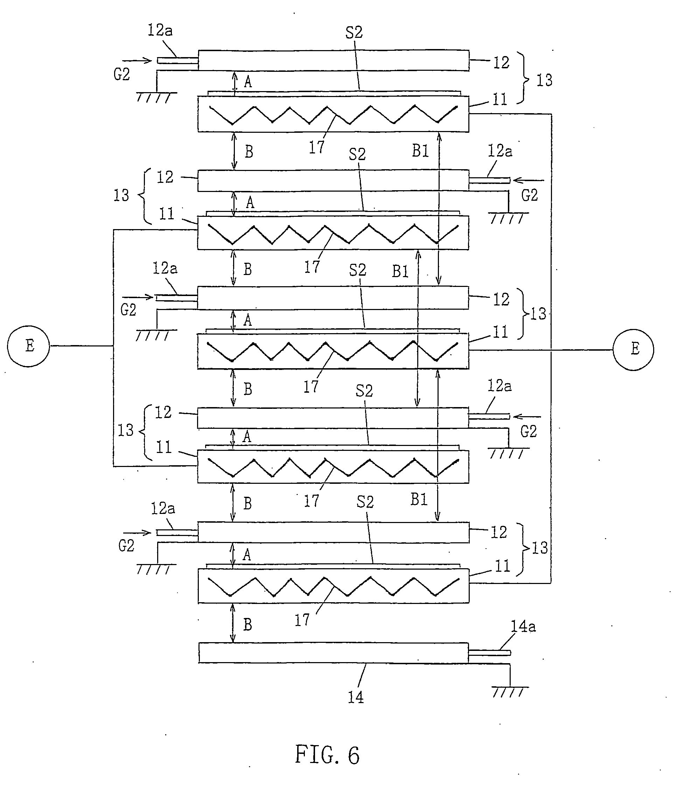

Fig. 6 is a schematic configuration diagram showing a seventh embodiment of the plasma processing apparatus of the present invention. In Fig. 6, constituents that are identical to those shown in Fig. 3 are denoted by identical reference characters.
The plasma processing apparatus of the sixth embodiment is the top-bottom parallel type etching purpose plasma processing apparatus, and is similarly structured as that of the third embodiment, except for a major difference in the connection mode between a plurality of the cathode electrodes 11 and the power supply portion E.

That is, in the case of the plasma processing apparatus, respective cathode electrodes 11 of at least two of the discharge portions 13 are connected to an identical power supply portion E, and respective cathode electrodes 11 of adjacent ones of the discharge portions 13 are: connected to an identical high frequency generator via separate amplifiers as in the connection mode (b); or connected to different high frequency generators via an amplifier as in the connection mode (c). In other words, respective cathode electrodes 11 of the adjacent ones of the discharge portions 13 are connected to the power supply portion E via different electrical systems. While the power supply portion E is illustrated two in number in Fig. 6, it does not necessarily mean separate power supply portions.
By connecting the cathode electrodes 11 to the power supply portion E in this manner, it becomes possible to set the inter-discharge portion distance B to be at least 1.5 times as great as the interelectrode distance A, which is narrower than in the third embodiment.

In a plurality of discharge portions 13 connected with the identical electrical system, it is preferable that the relative positional relationship between every cathode electrode 11 and the power supply position is identical, and that the relative positional relationship between every anode electrode 12 and the ground position is identical. As used herein, the state where "the relative positional relationship is identical" refers to a state in which the power supply position is identical in every cathode electrode 11 when each cathode electrode 11 is seen in plan view, and the ground position is identical in every anode electrode 12 when each anode electrode 12 is seen in plan view.
Thus, it becomes possible to more equally supply power from the power supply portion E to respective cathode electrodes 11 of a plurality of the discharge portions 13 connected with the identical electrical system.
That is, similarly to the first embodiment, the seventh embodiment is also structured as the structures (1-2), (2), (3-2), (4-2), (5-2), and (6-2) described in the foregoing.

### (Eighth Embodiment)

With reference to Fig. 6, the description has been given of the top-bottom parallel type etching purpose plasma processing apparatus. It is also possible to employ a sideways parallel type etching purpose plasma processing apparatus, whose structure corresponds to that of the aforementioned top-bottom parallel type etching purpose plasma processing apparatus substantially lying on its side (not shown). Similarly to the first embodiment, the eighth embodiment is also structured as the structures (1-2), (2), (3-2), (4-2), (5-2), and (6-2) described in the foregoing.

### (Other Embodiment)

In the first to eighth embodiments, the cases in which the first electrode of the discharge portion opposing (adjacent) to the dummy electrode and the first electrode of at least one other discharge portion are connected to the identical power supply portion have exemplarily been shown. However, it is also possible that the first electrode of the discharge portion opposing to the dummy electrode is connected to a power supply portion being different from a power supply portion to which the first electrode(s) of all the other discharge portion(s) are connected.

### INDUSTRIAL APPLICABILITY

The plasma processing apparatus of the present invention is applicable to, for example, a CVD apparatus used in the deposition step in the manufacturing process of various semiconductor devices such as a solar battery, a TFT, a photosensitive element, or an RIE apparatus used in the etching step.

### DESCRIPTION OF REFERENCE CHARACTERS

- 1, 11: first electrode (cathode electrode)
- 1a, 12a, 14a: gas inlet portion
- 2, 12: second electrode (anode electrode)
- 3, 13: discharge portion
- 4, 14: dummy electrode
- 5: support means (support piece)
- 6: exhaust portion
- 7, 17: heater
- A: interelectrode distance
- B: inter-discharge portion distance
- C: chamber
- E: power supply portion
- G 1, G2: reactant gas
- R: reaction chamber
- S1, S2: substrate (processing target object)

## Claims

1. A plasma processing apparatus, comprising:
a reaction chamber;
a plurality of discharge portions each made up of a pair of a first electrode and a second electrode disposed inside the reaction chamber so as to oppose to each other and to cause a plasma discharge under an atmosphere of a reactant gas; and
a dummy electrode, wherein
a plurality of the first electrodes are connected to a power supply portion,
a plurality of the second electrodes are grounded, and
the dummy electrode is disposed so as to oppose to an outer surface side of an external first electrode in terms of a parallel direction out of the plurality of the first electrodes which are disposed in the parallel direction, and is grounded.

2. The plasma processing apparatus according to claim 1, wherein
the first electrode opposing to the dummy electrode and at least one other first electrode out of the plurality of the first electrodes are connected to an identical one of the power supply portion.

3. The plasma processing apparatus according to claim 1 or 2, wherein
the dummy electrode is disposed such that a distance between the dummy electrode and the first electrode opposing to the dummy electrode is matched to an inter-discharge portion distance between a second electrode of one discharge portion out of the plurality of the discharge portions and a first electrode of other discharge portion adjacent thereto.

4. The plasma processing apparatus according to claim 1 or 2, wherein
the second electrodes and the dummy electrode are identical to each other in at least one of a shape, a size, and a material.

5. The plasma processing apparatus according to claim 1 or 2, wherein
the first electrodes, the second electrodes and the dummy electrode are structured with respective shapes, sizes and materials whereby their respective deflection amounts match to one another.

6. The plasma processing apparatus according to claim 1 or 2, wherein
the second electrodes and the dummy electrode are grounded at an identical point in each electrode.

7. The plasma processing apparatus according to claim 1 or 2, wherein
the first electrodes are connected to the power supply portion at an identical point in each electrode.

8. The plasma processing apparatus according to claim 1 or 2, wherein
the second electrodes and the dummy electrode each include therein a heater.

9. A deposition method carried out by using
a plasma processing apparatus that includes a reaction chamber, a plurality of discharge portions each made up of a pair of a first electrode and a second electrode disposed inside the reaction chamber so as to oppose to each other and to cause a plasma discharge under an atmosphere of a reactant gas, and a dummy electrode disposed so as to oppose to an outer surface side of an external first electrode in terms of a parallel direction out of a plurality of the first electrodes which are disposed in the parallel direction, the method comprising the step of
depositing a semiconductor film on a substrate, wherein
in a state where the substrate is placed on each of at least one of the second electrodes, and where the plurality of the second electrodes and the dummy electrode are grounded and the plurality of the first electrodes are supplied with power, the plasma discharge is caused by use of the reactant gas, to thereby carry out the depositing of the semiconductor film on the substrate.

10. The deposition method according to claim 9, wherein
the second electrodes and the dummy electrode are heated.

11. An etching method carried out by using
a plasma processing apparatus that includes a reaction chamber, a plurality of discharge portions each made up of a pair of a first electrode and a second electrode inside the reaction chamber so as to oppose to each other and to cause a plasma discharge under an atmosphere of a reactant gas, and a dummy electrode disposed so as to oppose to an outer surface side of an external first electrode in terms of a parallel direction out of a plurality of the first electrodes which are disposed in the parallel direction, the method comprising the step of
etching one of a semiconductor substrate and a semiconductor film on a substrate, wherein
in a state where one of the semiconductor substrate and the substrate having the semiconductor film thereon is placed on each of at least one of the first electrodes, and where a plurality of the second electrodes and the dummy electrode are grounded and where the plurality of the first electrodes are supplied with power, the plasma discharge is caused by use of the reactant gas, to thereby carry out the etching of one of the semiconductor substrate and the semiconductor film on the substrate.

12. The etching method according to claim 11, wherein
the first electrodes are heated.
